# EUROPEAN PATENT APPLICATION

(11) **EP 3 196 932 A1**
(43) Date of publication of application: **26.07.2017**
(21) Application number: 16152173.7
(22) Date of filing: 21.01.2016
(51) Int. Cl.: H01L 23/40, H01L 23/552, H01L 25/07, H01L 23/367, H01L 23/427

(54) **COOLED ELECTRICAL ASSEMBLY**

(71) Applicant: ABB Technology Oy, 00380 Helsinki (FI)
(72) Inventor: Skibin, Stanislav, 5405 Baden Daettwil (CH); Agostini, Bruno, 5405 Baden Daettwil (CH); Agostini, Francesco, 5405 Baden Daettwil (CH); Habert, Mathieu, 5405 Baden Daettwil (CH); Torresin, Daniele, 5405 Baden Daettwil (CH)
(74) Representative: Kolster Oy Ab

(57) **Abstract**

A cooled electrical assembly comprising an electric component element (2; 2b) comprising at least one electric component (21, 22 ; 21 b, 22b), a grounding element (4; 4b) adapted to ground the electric component element (2; 2b) during normal operation of the cooled electrical assembly, and a cooling element (6; 6b) adapted for transferring heat out of the electric component element (2; 2b), the cooling element (6; 6b) comprising electrically conducting material, and being attached to the electric component element (2; 2b) through assembly attachment means. The assembly attachment means are adapted to substantially prevent any grounding current from flowing in the cooling element (6; 6b) during normal operation of the cooled electrical assembly.

## Description

### FIELD OF THE INVENTION

The present invention relates to a cooled electrical assembly.

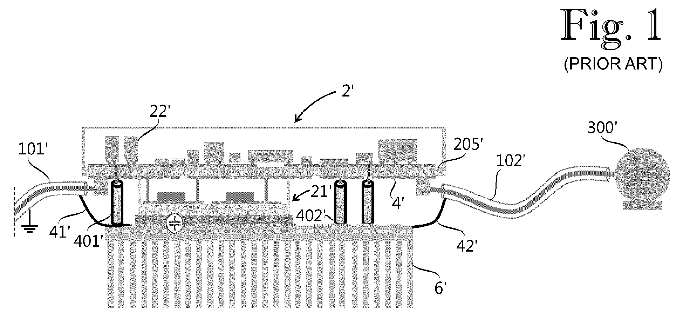

Figure 1 shows a known cooled electrical assembly comprising an electric component element 2' comprising electric components 21' and 22'; a grounding element 4' adapted to ground the electric component element 2' during normal operation of the cooled electrical assembly; and a cooling element 6' adapted for transferring heat out of the electric component element 2', the cooling element 6' comprising electrically conducting material, and being attached to the electric component element 2' through assembly attachment means.

The electric component element 2' comprises a circuit board 205' onto which the electric components 21' and 22' are mounted. The grounding element 4' of the cooled electrical assembly comprises a grounding layer integrated into the circuit board 205'. The grounding layer of the circuit board 205' is electrically conductively connected to the cooling element 6' in a plurality of points through grounding connectors 401' and 402'.

The cooled electrical assembly of Figure 1 also comprises an input cable 101' for supplying electric power to the electric component element 2', and an output cable 102' for supplying electric power out of the electric component element 2' into a motor 300'. The input cable 101' has an input cable shielding electrically conductively connected to a first end of the cooling element 6' through a grounding conductor 41'. During normal operation of the cooled electrical assembly the input cable shielding is electrically conductively connected to a main grounding of the cooled electrical assembly. The output cable 102' has an output cable shielding electrically conductively connected to a second end of the cooling element 6' through a grounding conductor 42'.

One of the problems associated with the cooled electrical assembly of Figure 1 is that during its normal operation there are grounding currents flowing in the cooling element 6'. For example, a grounding current can use the grounding connector 402' as an entry route from the electric component element 2' to the cooling element 6', and the grounding conductor 41' between the cooling element 6' and the input cable shielding of the input cable 101' as an exit route from the cooling element 6'. Also the grounding conductor 42' between the cooling element 6' and the output cable shielding of the output cable 102' provides a potential exit route for a grounding current. Therefore grounding currents can flow through the entire cooling element 6'. Since the cooling element 6' has a large surface area and comprises electrically conducting material, the cooling element 6' can be considered as a big antenna, which radiates EM waves in a very broad frequency range.

### BRIEF DESCRIPTION OF THE INVENTION

An object of the present invention is to reduce radiated electromagnetic emission of a cooled electrical assembly whose cooling element comprises electrically conducting material. The objects of the invention are achieved by a cooled electrical assembly which is characterized by what is stated in the independent claim. The preferred embodiments of the invention are disclosed in the dependent claims.

The invention is based on the idea of attaching a cooling element to an electric component element of a cooled electrical assembly such that flowing of substantially all grounding currents in the cooling element is prevented. Said prevention can be realized by assembly attachment means which electrically isolate a cooling element of a cooled electrical assembly from a grounding element of the cooled electrical assembly. Alternatively said prevention can be realized by assembly attachment means which comprise a single grounding connector electrically connecting the cooling element to the grounding element.

An advantage of the cooled electrical assembly according to the invention is that radiated electromagnetic emission is minimized because substantially no grounding currents flow in the cooling element during normal operation of the cooled electrical assembly.

### BRIEF DESCRIPTION OF THE DRAWINGS

In the following the invention will be described in greater detail by means of preferred embodiments with reference to the attached drawings, in which
Figure 1 shows a known cooled electrical assembly;
Figure 2 shows a partially disassembled cooled electrical assembly according to an embodiment of the invention;
Figure 3 shows the cooled electrical assembly of Figure 2 from a different direction;
Figure 4 shows a partially disassembled cooled electrical assembly according to another embodiment of the invention; and

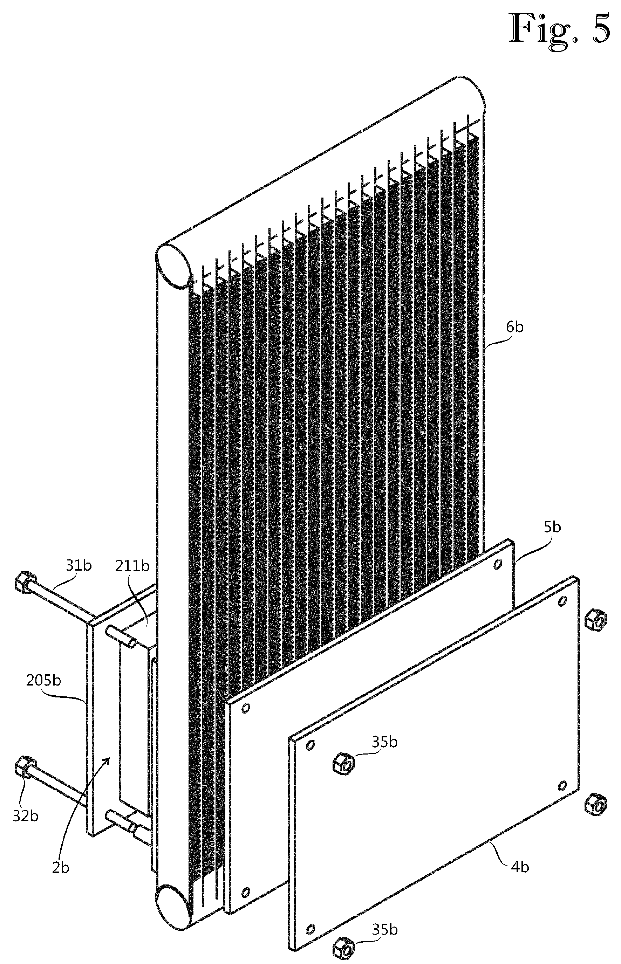

Figure 5 shows the cooled electrical assembly of Figure 4 from a different direction.

### DETAILED DESCRIPTION OF THE INVENTION

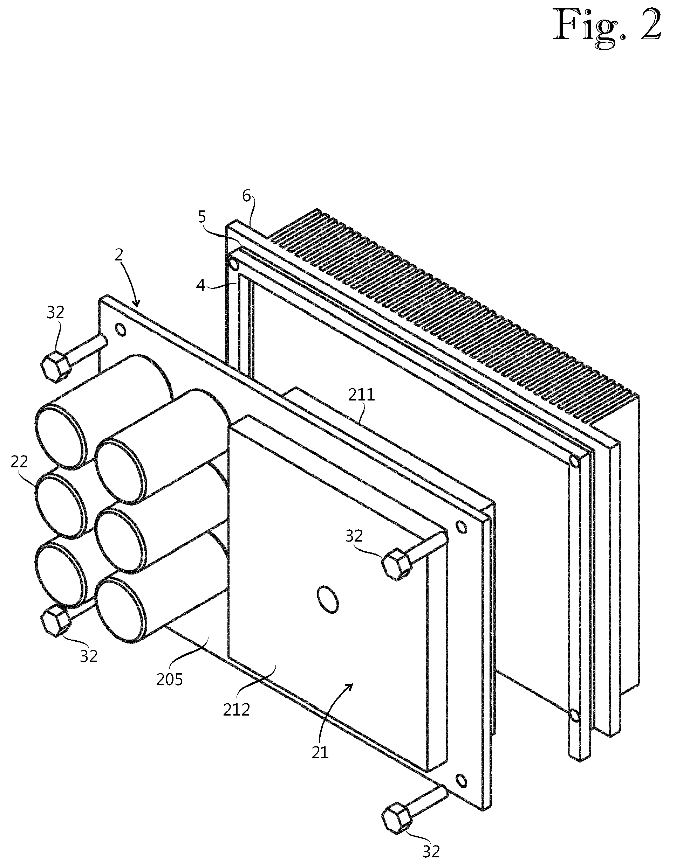

Figure 2 shows a partially disassembled cooled electrical assembly comprising an electric component element 2, a grounding element 4, an insulation element 5, a cooling element 6, and assembly attachment means. The electric component element 2 comprises a circuit board 205 onto which a first type electric component 21 and six second type electric components 22 are mounted. The grounding element 4 is made of electrically conducting material, and is adapted to ground the electric component element 2 during normal operation of the cooled electrical assembly. The assembly attachment means are adapted to attach the cooling element 6 to the electric component element 2. The cooling element 6 comprises a heat sink, and is adapted for transferring heat out of the electric component element 2.

The electric component element 2 comprises a frequency converter. The first type electric component 21 is a power module comprising a main part 211 located on a first side of the circuit board 205, and a connection part 212 located on a second side of the circuit board 205. The main part 211 comprises controllable semiconductor switches of the power module. The connection part 212 is adapted for fixing the main part 211 to the circuit board 205.

The electric component element 2 is adapted to be connected to an input cable for supplying electric power to the electric component element 2, and to an output cable for supplying electric power out of the electric component element 2. The input cable can have an input cable shielding, and the output cable can have an output cable shielding. Both the input cable shielding and the output cable shielding can be electrically connected to the grounding element 4.

In an assembled state of the cooled electrical assembly, the main part 211 is heat conductively connected to the cooling element 6. A majority of heat transfer from the main part 211 to the cooling element 6 is adapted to take place through thermal conduction. Each of the second type electric components 22 is a capacitor located on the second side of the circuit board 205. In alternative embodiments an electric component element comprises some other device adapted to convert electric energy from one form to another, such as a DC-to-DC converter or an inverter.

The insulation element 5 is located between the cooling element 6 and the grounding element 4 such that the insulation element 5 is sandwiched between the cooling element 6 and the grounding element 4, and is in contact with both of them. The insulation element 5 is adapted to electrically insulate the cooling element 6 from the grounding element 4. Each of the grounding element 4 and insulation element 5 is a basically U-shaped element. The main part 211 is surrounded by the grounding element 4 and insulation element 5 from three sides. In alternative embodiments a grounding element and/or an insulation element can be integrated into a circuit board. The integration can be realized by forming the grounding element and/or the insulation element as a layer of the circuit board.

The assembly attachment means are adapted to substantially prevent any grounding current from flowing in the cooling element 6 during normal operation of the cooled electrical assembly. The assembly attachment means comprise four fastening screws 32 adapted to attach the circuit board 205 to the grounding element 4, a first glue layer between the grounding element 4 and the insulation element 5, and a second glue layer between the insulation element 5 and the cooling element 6. The fastening screws 32 are electrically insulated from the cooling element 6.

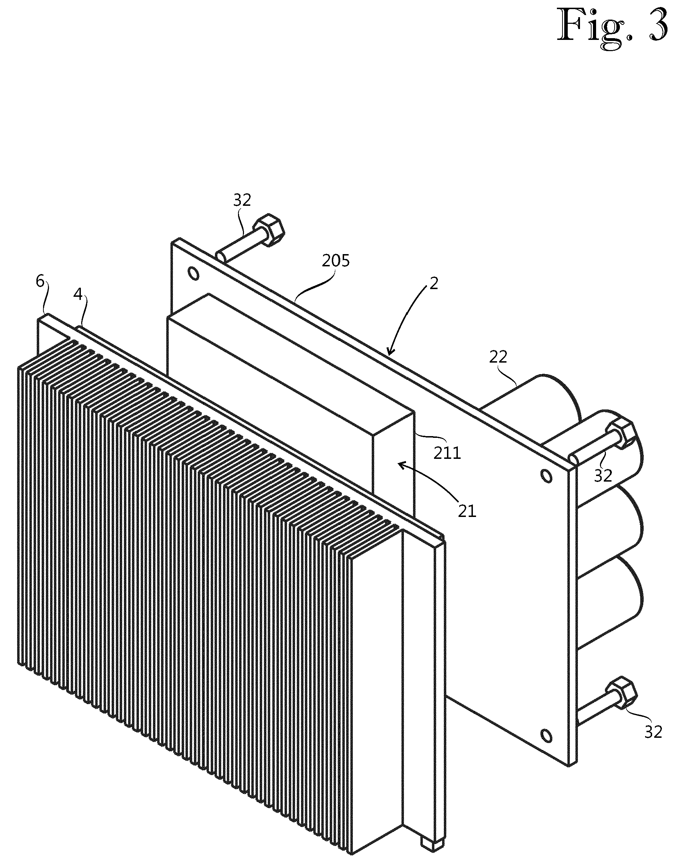

Figure 3 shows the cooled electrical assembly of Figure 2 from a different direction. Figure 3 shows that neither the second type electric components 22 nor the area of the circuit board 205 onto which the second type electric components 22 are mounted is in direct contact with the cooling element 6. The second type electric components 22 do not require powerful cooling since they only generate little heat unlike the first type electric component 21. The second type electric components 22 are adapted to be cooled mainly by convection, i.e. by air flowing around them.

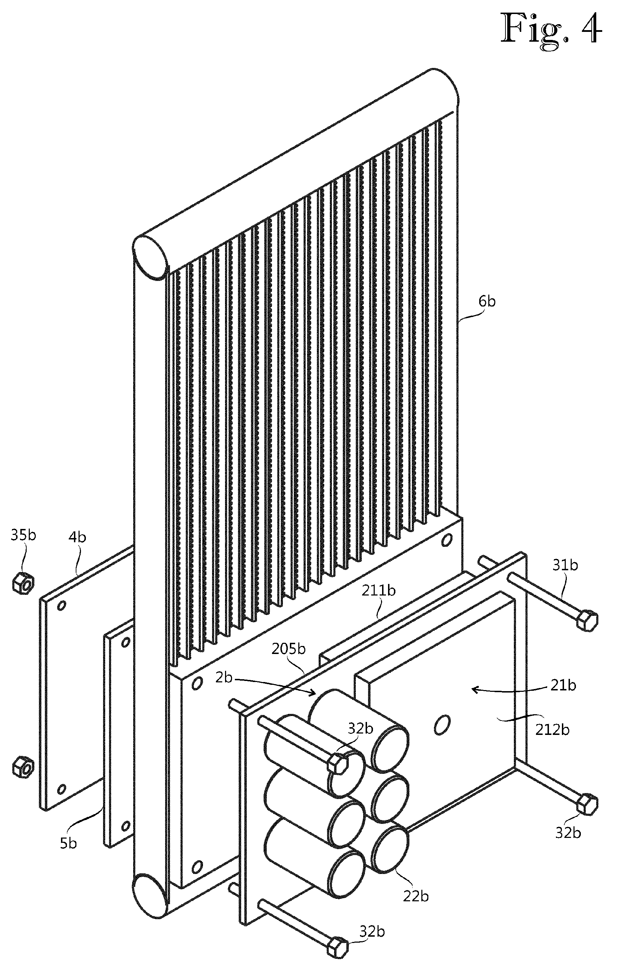

Electrical safety regulations often require that any part of a cooled electrical assembly which comprises electrically conducting material and can be touched by a person must be grounded. Figure 4 shows an embodiment of the invention, in which a cooling element of a cooled electrical assembly is adapted to be grounded. The cooled electrical assembly of Figure 4 comprises an electric component element 2b, a grounding element 4b, an insulation element 5b, a cooling element 6b, and assembly attachment means. The electric component element 2b comprises a circuit board 205b onto which a first type electric component 21 b and six second type electric components 22b are mounted. The electric component element 2b of Figure 4 is identical to the electric component element 2 of Figure 2. The grounding element 4b is adapted to ground the electric component element 2b during normal operation of the cooled electrical assembly. The cooling element 6b comprises a thermosyphon, and is adapted for transferring heat out of the electric component element 2b.

In an assembled state of the cooled electrical assembly, a main part 211 b of the electric component element 2b is heat conductively connected to the cooling element 6b. The grounding element 4b and the insulation element 5b are located on the opposite side of the cooling element 6b than the electric component element 2b. The insulation element 5b is sandwiched between the cooling element 6b and the grounding element 4b. Each of the grounding element 4b and the insulation element 5b is a plate having a rectangular shape.

The assembly attachment means are adapted to attach the cooling element 6b to the electric component element 2b, and to attach the grounding element 4b and the insulation element 5b to the cooling element 6b. In other words the assembly attachment means are adapted to hold the cooled electrical assembly together in an assembled state thereof. The assembly attachment means comprise a grounding screw 31 b, three fastening screws 32b, and four nuts 35b. One of the nuts 35b is adapted to co-operate with the grounding screw 31 b, and the rest of the nuts 35b are adapted to co-operate with the fastening screws 32b. A screw head of each of the grounding screw 31 b and fastening screws 32b is adapted to exert a force on the circuit board 205b, and each of the nuts 35b is adapted to exert a force on the grounding element 4b for holding the cooled electrical assembly together.

The assembly attachment means comprise a single grounding connector in a form of the grounding screw 31 b which electrically connects the cooling element 6b to the grounding element 4b. The assembly attachment means are adapted to substantially prevent any grounding current from flowing in the cooling element 6b during normal operation of the cooled electrical assembly because the single grounding connector does not provide a suitable route for a grounding current. Flow of grounding currents would require an entry route and an exit route spaced apart from each other, but a single grounding connector only provides one electrically conducting contact point.

The cooling element 6b is adapted to be grounded exclusively through the single grounding connector. Except for the single grounding connector the assembly attachment means are adapted to electrically isolate the cooling element 6b from the grounding element 4b. The cooling element 6b should not be grounded through one or more additional grounding connectors, because such a multipoint grounding connection could provide at least one harmful route for a grounding current allowing the grounding current to flow in the cooling element 6b during normal operation of the cooled electrical assembly.

The grounding screw 31 b is made of electrically conducting material such as steel. The cooling element 6b has an inside thread adapted to co-operate with an external thread of the grounding screw 31 b in order to provide a reliable electrically conducting connection between the cooling element 6b and the grounding screw 31 b. An electrically conducting connection between the grounding screw 31 b and the grounding element 4b is provided through the nut 35b adapted to co-operate with the grounding screw 31 b, said nut being made of electrically conducting material such as steel, and adapted to be in electrically conducting connection with the grounding element 4b.

Each of the fastening screws 32b is adapted to electrically isolate the cooling element 6b from the grounding element 4b. The fastening screws 32b are made of electrically insulating material. In an alternative embodiment the cooling element is provided with an oversized hole for each of the fastening screws such that there is no contact between the fastening screws and the cooling element. Herein, an oversized hole is a hole whose diameter is substantially larger than a diameter of corresponding fastening screw.

Shape and surface area of a single grounding connector is selected such that the single grounding connector itself does not provide any routes for grounding currents. In general, a simple shape with a small surface area is better than a complicated shape with a plurality of projections and a large total area. In an alternative embodiment a single grounding connector comprises a grounding conductor electrically connecting the cooling element to the grounding element.

The heat sink of the cooling element 6 and the thermosiphon of the cooling element 6b are made of aluminium. Both heat sink and thermosiphon are passive cooling devices. In alternative embodiments a cooling element of a cooled electrical assembly comprises a passive or active cooling device comprising aluminium, steel, copper or some other electrically conducting material. A cooling element comprising electrically conducting material is capable of reducing propagation of electromagnetic radiation thus acting as a shield against electromagnetic radiation.

It will be obvious to a person skilled in the art that the inventive concept can be implemented in various ways. The invention and its embodiments are not limited to the examples described above but may vary within the scope of the claims.

## Claims

1. A cooled electrical assembly comprising
an electric component element (2; 2b) comprising at least one electric component (21, 22 ; 21 b, 22b);
a grounding element (4; 4b) adapted to ground the electric component element (2; 2b) during normal operation of the cooled electrical assembly; and
a cooling element (6; 6b) adapted for transferring heat out of the electric component element (2; 2b), the cooling element (6; 6b) comprising electrically conducting material, and being attached to the electric component element (2; 2b) through assembly attachment means,
**characterized in that** the assembly attachment means are adapted to substantially prevent any grounding current from flowing in the cooling element (6; 6b) during normal operation of the cooled electrical assembly.

2. A cooled electrical assembly according to claim 1, **characterized in that** the assembly attachment means electrically isolate the cooling element (6; 6b) from the grounding element (4; 4b).

3. A cooled electrical assembly according to claim 1, **characterized in that** the assembly attachment means comprise a single grounding connector electrically connecting the cooling element (6b) to the grounding element (4b).

4. A cooled electrical assembly according to claim 3, **characterized in that** the single grounding connector comprises a grounding screw (31 b) or a grounding conductor.

5. A cooled electrical assembly according to any one of the preceding claims, **characterized in that** the cooled electrical assembly comprises an insulation element (5; 5b) adapted to electrically insulate the cooling element (6; 6b) from the grounding element (4; 4b).

6. A cooled electrical assembly according to any one of the preceding claims, **characterized in that** the electric component element (2; 2b) comprises a circuit board (205; 205b) onto which the at least one electric component (21, 22 ; 21 b, 22b) is mounted.

7. A cooled electrical assembly according to any one of the preceding claims, **characterized in that** the cooling element (6; 6b) comprises a passive cooling device such as a heat sink or a thermosyphon.
